# EUROPEAN PATENT APPLICATION

(11) **EP 2 733 749 A1**
(43) Date of publication of application: **21.05.2014**
(21) Application number: 12193086.1
(22) Date of filing: 16.11.2012
(51) Int. Cl.: H01L 31/0264, H01L 31/032, H01L 31/0224, H01L 31/0749

(54) **A solar cell**

(71) Applicant: Nederlandse Organisatie voor Toegepast -Natuurwetenschappelijk Onderzoek TNO, 2628 VK Delft (NL)
(72) Inventor: Buskens, Pascal Jozef Paul, 2628 VK Delft (NL); Vroon, Zeger Alexander Eduarol Pieter, 2628 VK Delft (NL); van Deelen, Joop, 2628 VK Delft (NL)
(74) Representative: Jansen, Cornelis Marinus

(57) **Abstract**

The invention relates to a solar cell. The solar cell comprises a structure of sandwiched layers for converting incident light into electrical energy. The structure includes an electrically conducting back contact layer, a light absorbing semiconductor layer located on the back contact layer, and a transparent conductive layer on top of the semiconductor layer. Further, the structure includes a group of metal nanoparticles forming a plasmonic nanostructure at a particular level in the sandwiched layers. The metal nanoparticles have a core containing non-metallic material and a shell containing metallic material covering the core.

## Description

The present invention relates to a solar cell, comprising a structure of sandwiched layers for converting incident light into electrical energy, the structure including an electrically conducting back contact layer, a light absorbing semiconductor layer located on the back contact layer, and a transparent conductive layer on top of the semiconductor layer, wherein the solar cell further comprises a group of metal nanoparticles forming a plasmonic nanostructure at a particular level in the sandwiched layers.

Such solar cells are known, e.g. as thin-film silicon solar cells. Here, the conventional solar cell layer structure containing a transparent conductive oxide (TCO) layer, a semiconductor layer and a back contact layer has been provided with a plasmonic nanostructure to increase the efficiency of the conversion from light to electric energy by scattering incident lightbeams. For thin-film silicon cells, efficiency enhancements of up to 44% have been demonstrated. Alternatively, these metal nanostructures can enable the use of thinner absorber layers without loss of efficiency. This is for example of interest for CIGS cells: these cells currently have a relatively thick, approx. 2.5 µm, and therefore expensive absorber layer. A significant reduction of absorber layer thickness without loss in efficiency would dramatically decrease the costs of a CIGS module.

To obtain the above-mentioned enhancement in cell efficiency, the metal nanomaterial are typically made from gold and silver. However, gold and silver material is costly.

It is an object of the invention to reduce the above-mentioned drawbacks while maintaining or further exploiting the above-mentioned advantages. More particular, it is an object of the invention to provide a solar cell having improved efficiency or similar efficiency with reduced thickness of semiconductor layer, while manufacturing costs are relatively moderate. Thereto, according to an aspect of the invention, the metal nanoparticles have a core containing non-metallic material and a shell covering the core and containing metallic material.

It is noted that the invention is at least partly based on the surprising insight that the scattering effects of the nanoparticles depend on the metal material type, the particle size, the particle shape, the metal on the outer surface of the particle, the material type inside the nanoparticles, and the use of the nanoparticles in the layer structure of the solar cell, such as the distribution density, the material adjacent to the nanoparticles, the dimensions and other materials of the stack of layers etc. Also the ratio between scattering and absorption of the nanoparticles is determined by the above-mentioned parameters.

Surprisingly, it has been found that metal nanoparticles having a core containing non-metallic material and a shell covering the core and containing metallic material generate comparable results in terms of scattering / absorption performance when comparing with massive nanoparticles, especially when using core material having a refractive index higher than 1, more preferably higher than circa 1.5. Then, costs can considerably be saved, since non-metallic core material is generally much cheaper than metallic material, at least when using noble metal material.

It also appears that when applying the metal nanoparticles according to the invention, not only the efficiency of incident light in the blue part of the spectrum increases, but also the efficiency of incident light having higher wavelengths, e.g. up to circa 600 nm, 800 nm, or even higher.

Other advantageous embodiments according to the invention are described in the following claims.

By way of example only, embodiments of the present invention will now be described with reference to the accompanying figures in which
Fig. 1 shows a schematic cross-sectional view of a solar cell according to the invention; and
Fig. 2 shows a schematic cross-sectional view of a metallic nanoparticle included in the solar cell of Fig. 1.

The figures are merely schematic views of preferred embodiments according to the invention. In the figures, the same reference numbers refer to equal or corresponding parts.

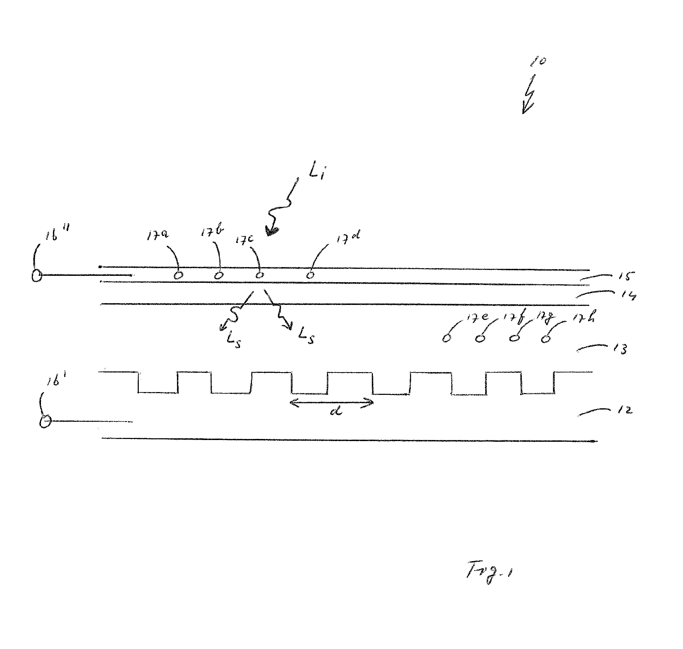

Figure 1 shows a schematic cross-sectional view of a solar cell 10 according to the invention. The solar cell 10 is of a so-called CIGS type, containing copper, indium, gallium and selenide in the light absorbing semiconductor material.

The solar cell 10 includes a number of subsequent layers built upon each other forming a sandwich structure for converting incident light Lᵢ into electrical energy. The sandwich structure includes an electrically conducting back contact layer 12, a light absorbing semiconductor layer 13 located on the back contact layer 12, and a transparent conductive oxide (TCO) layer 15 on top of the semiconductor layer 13. Further, the sandwich structure includes a buffer layer 14 sandwiched between the TCO layer 15 and the semiconductor layer 13. The solar cell 10 also includes a pair of electrodes 16', 16" connected to the TOC layer 15 and to the back contact layer 12.

During operation of the solar cell 12 the incident light Lᵢ is trapped in the semiconductor layer 13 accumulating an electric voltage on the electrodes 16', 16".

The solar cell 10 further comprises a group of metal nanoparticles 17 forming a plasmonic nanostructure at a particular level in the sandwich structure. In the embodiment shown in Fig. 1, the plasmonic nanostructure 17a-d on the left-hand side in the TCO layer 15, while the plasmonic nanostructure 17e-h on the right-hand side is embedded in the semiconductor layer 13.

The plasmonic nanostructure 17 strongly interacts with the incident light Lᵢ generating scattered light beams Lₛ for concentrating and folding light in the semiconductor layer 13. By propagating the scattered light beams Lₛ into high-index material, reflection to the TCO layer 15 is counteracted. Further, the angular redistribution of the scattered light Lₛ also contributes to light being trapped since the optical path length inside the semiconductor layer 134 is enlarged.

The individual nanoparticles have a core 18 containing non-metallic material and a shell 19 covering the core and containing metallic material.

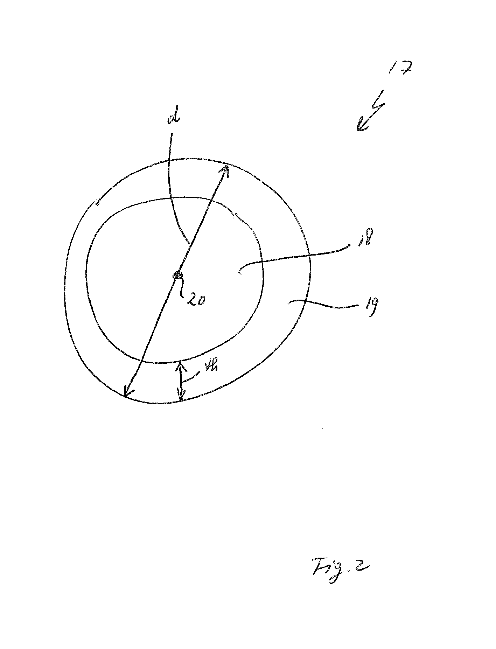

Figure 2 shows a schematic cross-sectional view of a metallic nanoparticle 17. The non-metallic core 18 material may e.g. include dielectric material and/or semiconductor material. As an example of dielectric material, the core 18 is made from a polymer dielectric such as polystyrene dielectric, or silica. Preferably, the metallic shell material includes silver, gold, copper and/or aluminium. Highly preferable, the shell 19 is made from silver since silver material is relatively stable, from a chemical point of view, and cheaper than gold. The shell 19 covers the core 18 as a coating or envelope.

The nanoparticles 17 have a mainly spherical shape. However, the nanoparticles 17 can be made in other shapes as well, e.g. an ellipsoidal shape. Generally, the size of the metal nanoparticles 17 in at least one dimension ranges from circa 0.05 micrometer to circa 0.25 micrometer. In case of a mainly spherical shape, as shown in Fig. 2, the diameter d running through a center point 20 is preferably within a range from circa 0.05 micrometer to circa 0.25 micrometer. In an advantageous manner, the nanoparticles 17 are monodisperse having the same size. Alternatively, the sizes of the nanoparticles 17 have a certain size distribution. If the dimensions of the nanoparticles 17 are too small, the scattering effects of the nanoparticles 17 decrease while the absorption of the incident light by the nanoparticles 17 increases, thereby reducing the efficiency of the solar cell 10. On the other hand, if the dimensions of the nanoparticles 17 are too large, the increase in scattering effect diminishes, also in view of the sizes of other structures in the solar cell 10. Then, the increase in metallic shell material that is required for forming the shell 19 has no additional contribution to the efficiency in trapping light.

The thickness th of the shell 19 is at most circa 0.05 micrometer. Typically, the shell thickness th ranges between circa 0.01 micrometer and circa 0.02 micrometer.

In preferred embodiments, the metal nanoparticles 17 are located on top of the TCO layer 15 or on top of the back contact layer 12. However, the metal nanoparticles 17 can also be embedded in the semiconductor layer 13, 14, as shown in Fig. 1, or can be located on top of the TCO layer 16.

The back contact layer 12 is provided with a grating profile having a spatial periodicity d to guide light having a matching wavelength range, thereby increasing the optical path length and the corresponding trapping occurrence. Alternatively, the back contact layer 12 has another profile, e.g. a flat interface with the semiconductor layer 13, 14.

The invention is not restricted to the embodiments described herein. It will be understood that many variants are possible.

As an example, the plasmonic nanostructure in the structure of sandwiched layers can not only be applied to CIGS solar cells, but also in other solar cells such as thin-film Si solar cells.

Further, it is noted that as an alternative to the TCO layer, another top layer can be applied, the top layer being transparent and electrically conductive.

Other such variants will be apparent for the person skilled in the art and are considered to fall within the scope of the invention as defined in the following claims.

## Claims

1. A solar cell, comprising a structure of sandwiched layers for converting incident light into electrical energy, the structure including an electrically conducting back contact layer, a light absorbing semiconductor layer located on the back contact layer, and a transparent conductive layer on top of the semiconductor layer, wherein the solar cell further comprises a group of metal nanoparticles forming a plasmonic nanostructure at a particular level in the sandwiched layers, and wherein the metal nanoparticles have a core containing non-metallic material and a shell covering the core and containing metallic material.

2. A solar cell according to claim 1, wherein the non-metallic core material includes dielectric material and/or semiconductor material.

3. A solar cell according to claim 1 or 2, wherein the metallic shell material includes silver, gold, copper and/or aluminium.

4. A solar cell according to any of the preceding claims, wherein the size of the metal nanoparticles in at least one dimension ranges from circa 0.05 micrometer to circa 0.25 micrometer.

5. A solar cell according to any of the preceding claims, wherein the thickness of the shell is at most circa 0.05 micrometer.

6. A solar cell according to any of the preceding claims, wherein the metal nanoparticles are mainly spherical.

7. A solar cell according to any of the preceding claims, wherein the metal nanoparticles are embedded in the transparent conductive layer or in the semiconductor layer.

8. A solar cell according to any of the preceding claims, wherein the metal nanoparticles are located on top of the transparent conductive layer or on top of the back contact layer.

9. A solar cell according to any of the preceding claims, further comprising a pair of electrodes connected to the transparent conducting layer and to the back contact layer, respectively.

10. A solar cell according to any of the preceding claims, wherein the semiconductor material contains CIGS material.

11. A solar cell according to any of the preceding claims, wherein the transparent conductive layer is a transparent conductive oxide layer.
